(19)

Europäisches
Patentamt
European
Patent Office
Office européen
des brevets

(11) **EP 4 439 308 A1**

(12) **EUROPEAN PATENT APPLICATION**

(43) Date of publication:
**02.10.2024 Bulletin 2024/40**

(21) Application number: **23165627.3**

(22) Date of filing: **30.03.2023**

(51) International Patent Classification (IPC):
**G06F 11/36** *(2006.01)* **B60W 50/00** *(2006.01)*
**G06F 30/20** *(2020.01)*

(52) Cooperative Patent Classification (CPC):
**G06F 11/3692; G06F 11/3668; G06F 11/3696;
G06F 30/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Siemens Industry Software NV
3001 Leuven (BE)**

(72) Inventors:
• **ATHAIYA, Snigdha
302004 Jaipur (IN)**
• **MASKERI RAMA, Girish
560095 Bangalore (IN)**

(74) Representative: **Isarpatent
Patent- und Rechtsanwälte Barth
Charles Hassa Peckmann & Partner mbB
Friedrichstrasse 31
80801 München (DE)**

(54) **SYSTEM AND METHOD FOR MANAGING PERCEPTION-BASED SYSTEMS**

(57) A system and a method for managing a perception-based system (PBS) are disclosed. The method comprises receiving formal requirements of the PBS expressed in a specification language. The method further comprises determining PBS properties based on an analysis of the formal requirements of the PBS which quantifies the formal requirements of the PBS over space and time. The method further comprises analysing, for a given input, an output of the PBS to determine a logical state thereof at a given time instance. The method further comprises determining a temporal robustness value indicative of a degree of closeness between the output of the PBS and a failure of the formal requirements based on the determined PBS properties and the determined logical state. The method further comprises generating a resultant output indicative of at least one of violation(s) and edge-case(s) of the PBS based on the determined temporal robustness value.

FIG 2

**Description**

The present disclosure relates to perception-based systems, and in particular to real-time monitoring of perception based system for violation(s) and edge-case(s) detection in a fine-grained and precise manner.

The prevalence of autonomous systems, such as driverless cars, autonomous drones, robotic units, and warehouses, has highlighted the significance of robust perception-based systems. These systems rely on perception modules that utilize visual data input from cameras and other sensors to estimate the surrounding environment. The modules are responsible for object identification and enabling real-time decision-making in critical situations. However, in complex autonomous systems operating in variable environmental conditions, unforeseeable challenges and safety risks are unavoidable.

It is crucial to ensure the safety and accuracy of perception modules in such scenarios to develop a reliable system. However, these modules are primarily composed of complex neural networks, which function as black boxes. Although sophisticated neural networks and learning algorithms provide exceptional performance, they lack module transparency, making it challenging to perform formal verification or white-box testing to establish system reliability.

Understandably, both of these verification and testing procedures are the primary methods for a complete safety analysis. It is pertinent to note that these systems can exhibit a completely unpredictable and error-prone behaviour with a marked decline in performance when faced with unfamiliar data or the input parameters that do not belong to known set of categories. This renders testing insufficient and unreliable during execution time. Besides, it will not be possible to generalize the performance of prediction-based systems over untrained datasets.

Continuous monitoring of these perception-based systems is therefore imperative for detecting the safety and correctness of such systems. Some studies in the art have explored the use of online monitoring systems for general cyber-security systems. Additionally, efforts have been made to monitor perception-based robots in real-time. However, these approaches are limited by the absence of a principled methodology that considers not only the perception module but also the entire robotic system and the interaction between modules during runtime.

Some previous attempts have developed a suite of tools for monitoring the output of simulation in dynamical systems and hybrid automata, both online and offline. These tools employ Metric Temporal Logic (MTL) as the specification language. However, their online monitor requires complete information regarding objects present in the entire scenario for expressing and verifying the specifications. As a result, these tools are less effective for real-time perception-based systems that operate in arbitrary and non-deterministic environments.

Another known online monitoring tool uses Timed Quantified Temporal Logic (TQTL) specifications to express specifications and can be used with both simulated and physical perception-based systems. However, edge-case detection using this tool is complex, as it requires the user to express all edge cases explicitly. Similarly, the work on model assertions aims to address this challenge using a code-based solution but has not produced satisfactory results. Thus, existing methods can only detect specification violations but not edge cases, including the detection of potential system failures in the future in real-world systems.

In light of the above limitations, there exists a need for an efficient, scalable, and user-friendly online monitoring system and method, which can detect safety and functional violations and edge-cases in a non-invasive manner, which can be integrated in a plug-and-play manner for management of perception-based system.

The object of the present disclosure is achieved by a method for managing a perception-based system (PBS). The method comprises receiving formal requirements of the PBS expressed in a specification language based on a predefined template. The method further comprises determining PBS properties based on an analysis of the received formal requirements of the PBS, wherein the PBS properties quantifies the formal requirements of the PBS over space and time. The method further comprises analysing, for a given input, an output of the PBS to determine a logical state thereof at a given time instance. The method further comprises determining a temporal robustness value indicative of a degree of closeness between the output of the PBS and a failure of the formal requirements based on the determined PBS properties and the determined logical state of the PBS. The method further comprises generating a resultant output indicative of at least one of violation(s) and edge-case(s) of the PBS based on the determined temporal robustness value.

In one or more embodiments, the given input is in form of a video feed of the PBS. In such case, the generated resultant output is in form of a portion of the video feed indicative of the at least one of violation(s) and edge-case(s) of the PBS.

In one or more embodiments, the method further comprises generating a corrective action for the PBS in response to the at least one of violation (s) and edge-case (s) of the PBS in the generated resultant output. In some embodiments, the method further comprises training a learning model, associated with the PBS, based on the given input and the generated corrective action for the at least one of violation(s) and edge-case(s) of the PBS corresponding thereto.

In one or more embodiments, the predefined template for the specification language is expressive of domain specific safety and functional properties of the PBS.

In one or more embodiments, the determined PBS properties are in form of Metric First Order Temporal Logic (MFOTL) properties expressed over logical state traces. Herein, each of the logical state traces is a sequence of PBS states at given periodic time-points. Further, herein each of the PBS state is expressed as a value for each formal requirements of the PBS at a given time-point.

In one or more embodiments, the given input is in the form of a video feed of the PBS. Herein, the output of the PBS comprises a set of detected objects at each time instance in the video feed of the PBS.

In one or more embodiments, the determined temporal robustness value being zero signifies violation(s) of the PBS. Herein, the determined temporal robustness value between zero and a predetermined threshold signifies edge-case(s) of the PBS.

In another object of the present disclosure, a system for managing a perception-based system (PBS) is provided. The system comprises an interface providing a predefined template. The interface is configured to receive formal requirements of the PBS expressed in a specification language based on the predefined template. The system further comprises a processor and a memory coupled to the processor. Herein, the memory comprises instructions which, when executed by the processor, configures the processor to determine PBS properties based on an analysis of the received formal requirements of the PBS. Herein, the PBS properties quantifies the formal requirements of the PBS over space and time. The processor is further configured to analyse, for a given input, an output of the PBS to determine a logical state thereof at a given time instance. The processor is further configured to determine a temporal robustness value indicative of a degree of closeness between the output of the PBS and a failure of the formal requirements based on the determined PBS properties and the determined logical state of the PBS. The processor is further configured to generate a resultant output indicative of at least one of violation(s) and edge-case(s) of the PBS based on the determined temporal robustness value.

In still other object of the present disclosure, a computer-program product is provided, having machine-readable instructions stored therein, that when executed by a processor, cause the processor to perform the aforementioned method steps.

The present disclosure is not limited to a particular computer system platform, processor, operating system, or network. One or more aspects of the present disclosure may be distributed among one or more computer systems, for example, servers configured to provide one or more services to one or more client computers, or to perform a complete task in a distributed system. For example, one or more aspects of the present disclosure may be performed on a client-server system that comprises components distributed among one or more server systems that perform multiple functions according to various embodiments. These components comprise, for example, executable, intermediate, or interpreted code, which communicate over a network using a communication protocol. The present disclosure is not limited to be executable on any particular system or group of systems, and is not limited to any particular distributed architecture, network, or communication protocol.

The above-mentioned and other features of the invention will now be addressed with reference to the accompanying drawings of the present disclosure. The illustrated embodiments are intended to illustrate, but not limit the invention.

The present disclosure is further described hereinafter with reference to illustrated embodiments shown in the accompanying drawings, in which:

FIG 1    is a block diagram representation of a system for managing a perception-based system (PBS), according to one or more embodiments of the present disclosure;

FIG 2    is a block diagram representation of an architecture for implementation of the system for managing the PBS, according to one or more embodiments of the present disclosure;

FIG 3    is a block diagram representation of an approach adopted for online monitoring of the PBS, according to one or more embodiments of the present disclosure;

FIG 4    is a block diagram representation of algorithmic approach for the system for online monitoring of the PBS, according to one or more embodiments of the present disclosure; and

FIG 5    is a flowchart of a method for managing the PBS, according to one or more embodiments of the present disclosure.

Hereinafter, embodiments for carrying out the present disclosure are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

It may be appreciated that throughout this description the term "mechanism", "approach" or "technique" will be used to refer to aspects of the present disclosure that perform various operations, functions, and the like. A "mechanism," as the term is used herein, may be an implementation of the functions or aspects of the illustrative embodiments in the form of a system, a method, or a computer program product. In the case of a method, the method steps are implemented by one or more devices, apparatus, computers, data processing systems, or the like. In the case of a computer program product, the logic represented by computer code or instructions embodied in or on the computer program product is executed by one or more hardware devices in order to implement the functionality or perform the operations associated with the specific "mechanism." Thus, the mechanisms described herein may be implemented as specialized hardware, software executing on general-purpose hardware, software instructions stored on a medium such that the instructions are readily executable by specialized or general purpose hardware, a procedure or method for executing the functions, or a combination of any of the above.

In addition, it should be appreciated that the following description uses a plurality of various examples for various elements of the illustrative embodiments to further illustrate example implementations of the illustrative embodiments and to aid in the understanding of the mechanisms of the illustrative embodiments. These examples intended to be non-limiting and are not exhaustive of the various possibilities for implementing the mechanisms of the illustrative embodiments. It will be apparent to those of ordinary skill in the art in view of the present description that there are many other alternative implementations for these various elements that may be utilized in addition to, or in replacement of, the examples provided herein without departing from the spirit and scope of the present disclosure.

The present disclosure is directed towards managing a perception-based system (PBS) by continual online monitoring thereof, that ensures safety and correctness of system in real time, in a fine-grained and precise manner. Broadly, in an online monitoring of such perception-based systems, the user provides a safety/functional specification, usually in a temporal logic template, and the system is verified if it is satisfying the user provided specification in real-time. This online monitoring can also be used to detect the possibility of a failure in future based on the current state of the system; these scenarios being referred to as violations/edge-cases.

Violation and edge-case detection during online monitoring enables the transfer of control back to safe modules or human operators when the system is about to perform incorrectly or in-optimally. But designing and formally expressing these edge cases is a non-trivial task, especially in complicated perception-based systems. Online monitoring provides the added advantage of being versatile and useful for almost every stage of the machine learning pipeline. This is particularly advantageous in cyber-physical systems that comprises of many safety critical components that needs to be continually verified for their correctness during run time.

In accordance with one working embodiment, the perception-based systems are monitored for rich functional and safety properties in real time and for detection of edge-cases or violations. This is primarily achieved by a two-step process comprising:

    a) Expression of rich functional and safety properties of perception-based systems in a user-friendly manner.
    b) Monitoring and detection of violations and edge-case violations of properties in perception-based systems

Now, each of these steps are described in greater detail hereafter. To begin with, the system requires expression of rich functional and safety properties of perception-based systems. Accordingly, it is desired that users express and verify system-level safety and functional properties, without having to undergo any formal mathematical training. The interface of such a tool is made natural and user-friendly for the domain users but should not be so simple that it is rendered useless. Keeping in mind this delicate balance, the present disclosure proposes the following elements, namely (a) Specification Language; (b) Metric First Order Temporal Logic (MFOTL) expressiveness.

In accordance with first aspect, the specification language is defined, which is precisely a template-based specification language, rich enough to specify powerful specifications in the system being monitored. The objective is to offer a language that is close to natural language and reflects the properties in the domain, facilitating ease of use for domain user. For instance, the proposed templates may be of the following form: "X never happens", "if W happens then Y happens within T seconds", or "Z always happens".

Here, the variables X, W, Y, and Z are placeholders for domain specific events and object characteristics detected by the perception-based system. The system thereby enables the user to combine these templates to form more sophisticated specifications. Using the above templates, the users will be able to express properties such as - an automated car never collides with a pedestrian, the water outlet stops filling the tank within 1s of the sensor going off, the railway gate closes within 2s of approaching train detection, every object is detected with a minimum confidence across the stream, the objects to do not flicker due to object detector malfunction, and the like.

In accordance with second aspect, Metric First Order Temporal Logic (MFOTL) expressiveness is explained in sufficient detail. Under the hood, the natural language specifications are translated to a fragment of Metric First Order Temporal Logic. MFOTL properties allow quantification over time as well as space of objects in a universe. The logic is ideal for expressing safety and functional properties in a perception-based system. The advancement made to MFOTL fragment is an extension of classic Metric Temporal Logic with variable support, quantification, and predicates over detected objects in the perception-based systems. Herein, Metric Temporal Logic (MTL) facilitates formalization of real-time specifications for testing of real-time system properties.

In the next working embodiment, the second sub-process whereby monitoring and detection of violations and edge-case violations of properties in perception-based systems is described. In real-time, for safety-critical systems or tracking systems it is ideal that the user is notified of an impending anomaly before the anomaly arises. These warnings can save resources and make the system resilient. To achieve this, the present disclosure introduces following technical components, namely, (a) MFOTL robustness; (b) Logical trace generator.

Accordingly, MFOTL robustness uses the concept of robustness of temporal specifications to not just provide satisfaction results for the input specification, but also a measure of how close the trajectory is violating the input specification. In general, a temporal robustness value close to zero signifies an edge case. Temporal robustness value of the input stream with respect to the specification allows detection of edge cases.

The robustness calculation is built on computing the robustness of Metric temporal Logic specifications and extends the computations to include the effects of quantification and domain specific predicates. These non-trivial extensions make the tool significantly more expressive, versatile, and effective.

In another aspect, the logical trace generator component is described. The output of perception-based system is a video stream or text-based file from object-detectors or object trackers. On the other hand, the MFOTL properties are expressed over logical state traces, where trace is a sequence of system states at some periodic time-points, and system state is expressed as the value for each system element at a given point in time. The Logical Trace generator component is a lean layer between the perception-based system and the robustness calculator that converts the system output stream to a logical trace. This component allows the monitor to act in a plug-and-play manner.

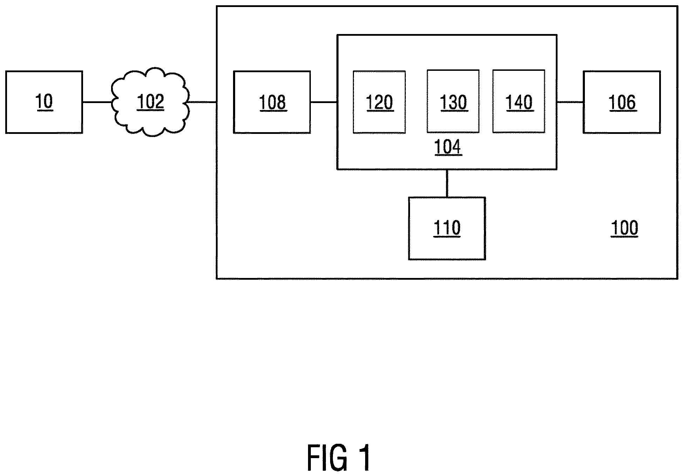

Referring to FIG 1, illustrated is a block diagram of a system 100 for managing a perception-based system (as represented by reference numeral 10), according to one or more embodiments of the present disclosure. As used herein, the perception-based system 10 is a system that is designed to sense, interpret, and understand the world around them using a variety of sensors, such as cameras, microphones, radar, lidar, or other types of sensors. Such system use machine learning algorithms and artificial intelligence techniques to process the data from the sensors and extract relevant information about the environment. Perception-based systems can be found in a wide range of applications, including autonomous vehicles, robotics, surveillance systems, and smart homes, among others. In autonomous vehicles, perception-based systems are used to detect obstacles, pedestrians, traffic signs, and other vehicles on the road, and to make decisions based on this information. In robotics, perception-based systems are used to detect objects, track their movements, and understand the environment in which the robot is operating. In surveillance systems, perception-based systems are used to detect and track suspicious behaviour, and to alert security personnel in real-time.

Further, as used herein, the management of the perception-based system 10 includes online monitoring of the perception-based system, which involves continuously checking the system's behaviour and performance in real-time to ensure that it is functioning correctly and safely. The perception-based system is monitored to detect violations of user-defined specifications, which can be used to identify edge cases and potential failures before they occur. In some examples, the management of perception-based systems also involves designing and implementing strategies to ensure the safe and effective operation of these systems. This includes developing and testing algorithms for perception, decision-making, and control, as well as integrating these algorithms into a larger system architecture. Other aspects of management may include designing and testing sensors, developing user interfaces, and maintaining the system over its lifecycle.

It may be appreciated that the system 100 described herein may be implemented in various forms of hardware, software, firmware, special purpose processors, or a combination thereof. For example, the system 100 may be incorporated in one or more physical packages (e.g., chips). By way of example, a physical package includes an arrangement of one or more materials, components, and/or wires on a structural assembly (e.g., a baseboard) to provide one or more characteristics such as physical strength, conservation of size, and/or limitation of electrical interaction. It is contemplated that in certain embodiments the computing device may be implemented in a single chip.

As illustrated, the system 100 may be implemented in on one or more computing devices in communication with each other over a computer network 102 via one or more wired and/or wireless data communication links, where each communication link comprises one or more of wires, routers, switches, transmitters, receivers, or the like. Other embodiments of the system 100 may be used with components, systems, sub-systems, and/or devices other than those that are depicted herein. The computer network 102 includes local network connections and remote connections in various embodiments, such that the system 100 may operate in any of local or global environments.

In certain embodiments, the computing devices includes a processor 104 and a memory 106. Herein, the memory 106 is communicatively coupled to the processor 104. In an example, the memory 106 may be embodied as a computer readable medium on which program code sections of a computer program are saved, the program code sections being loadable into and/or executable in a system to make the system 100 execute the steps for performing the said purpose. The computing device may further include a mass storage device for storing program modules. The program modules may include modules executable to perform one or more functions associated with embodiments of the present disclosure. Example computing devices include a mobile computing device such as a laptop or a mobile phone, a tablet computer, or other communication device, a personal digital assistant (PDA), or the like. Those of ordinary skill in the art will appreciate that the hardware discussed above may vary depending on the implementation.

Generally, the processor 104 may be a computational element that is operable to respond to and processes instructions that drive the system 100. Optionally, the processor 104 includes, but is not limited to, a microprocessor, a microcontroller, a complex instruction set computing (CISC) microprocessor, a reduced instruction set (RISC) microprocessor, a very long instruction word (VLIW) microprocessor, or any other type of processing circuit. Furthermore, the processor 104 may refer to one or more individual processors, processing devices and various elements associated with a processing device that may be shared by other processing devices. Additionally, the one or more individual processors, processing devices and elements are arranged in various architectures for responding to and processing the instructions that drive the system 100.

Further, the memory 106 may be volatile memory and/or nonvolatile memory. The memory 106 may be coupled for communication with the processor 104. The processor 104 may execute instructions and/or code stored in the memory 106. A variety of computer-readable storage media may be stored in and accessed from the memory 106. The memory 106 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

The system 100 may further include an input device 108 and an output device 110. The input device 108 may take various forms depending on the specific application of the system 100. In an example, the input device 108 may include one or more of a keyboard, a mouse, a touchscreen display, a microphone, a camera, or any other hardware component that enables the user to interact with the system 100. Further, the output device 110 may be in the form of a display. It is to be understood that, when reference is made in the present disclosure to the term "display" this refers generically either to a display screen on its own or to the screen and an associated housing, drive circuitry and possibly a physical supporting structure, of which all, or part of is provided for displaying information.

In the present system 100, the processor 104 and accompanying components have connectivity to the memory 106 which stores executable instructions to be executed by the processor 104 for managing the perception-based system. In particular, the processor 104 may incorporate multiple modules to perform steps for managing the perception-based system 10. Herein, as illustrated, the processor 104 includes a logical trace generator module 120 (hereinafter, referred to as logical trace generator 120), a robustness calculator module 130 (hereinafter, referred to as robustness calculator 130), and a temporal property analyser module 140 (hereinafter, referred to as temporal property analyser 140). In the present system 100, the logical trace generator 120, the robustness calculator 130 and the temporal property analyser 140 are incorporated in a manner to provide for plug-and-play monitoring of the perception-based system 10.

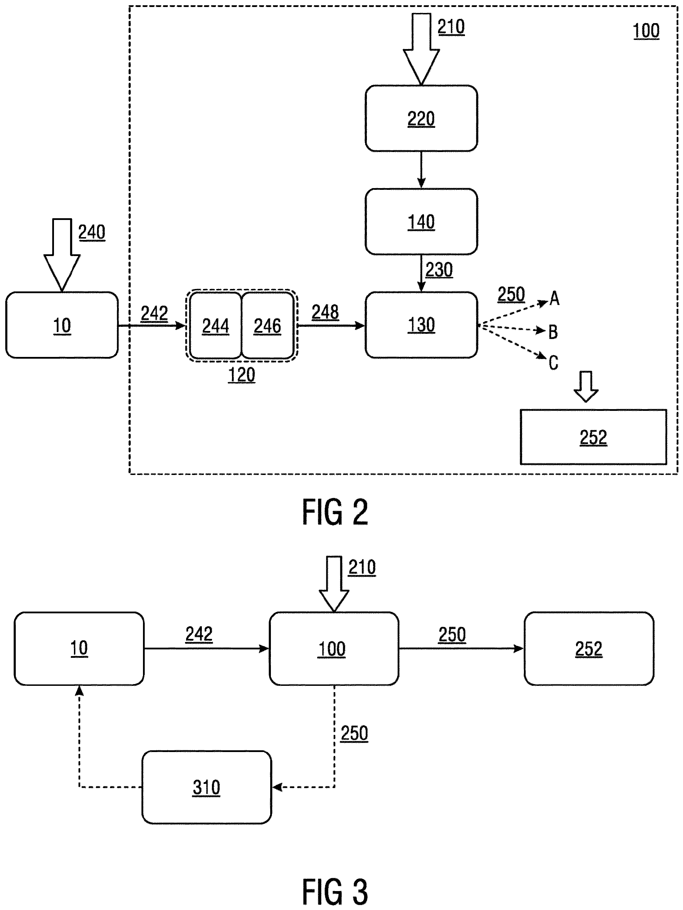

Referring to FIG 2, illustrated is an architecture for implementation of the system 100 for managing the perception-based system (PBS) 10. As used herein, the PBS 10 may be implemented in a PBS simulator (with the two terms being interchangeably used hereinafter). The simulator is a software tool that simulates the behaviour of the PBS 10 in a virtual environment. The simulator generates realistic input data and can emulate the output of the PBS 10 in response to that data. It may be appreciated that by using the simulator, the system 100 can be tested in a safe and controlled environment without risking damage to real-world assets or systems. By feeding the simulator with different types of input data, the output of the PBS 10 can be analysed to determine its behaviour and identify any issues or edge cases.

Herein, the system 100 receives formal requirements (referred by reference numeral 210) of the PBS 10 expressed in a specification language based on a predefined template. In particular, the system 100 provides an interface (represented by reference numeral 220) providing the predefined template. As may be contemplated, the interface 220 referred to in the system 100 may be a graphical user interface that provides the predefined template for specifying the formal requirements of the PBS 10. The interface 220 may be associated with the input device 108 of the system 100 for receiving the formal requirements of the PBS 10. In the present embodiments, the interface 220 is configured to receive formal requirements 210 of the PBS 10 expressed in a specification language based on the predefined template. The specification language can be a domain-specific language (DSL) that is designed specifically for describing perception-based systems, or it can be a general-purpose language that has been adapted for this purpose. Examples of specification languages used for describing perception-based systems may include Metric Temporal Logic (MTL), Signal Temporal Logic (STL) and Linear Temporal Logic (LTL), as known in the art.

Herein, the template is in a pre-defined format for defining the requirements of the PBS 10. Herein, the predefined template for the specification language is expressive of domain specific safety and functional properties of the PBS 10. The template is based on a specification language that is designed to capture the requirements of the PBS 10 over space and time. Specifically, the template may include a set of pre-defined parameters, data types, and constraints that the user can select and customize to specify the formal requirements of the PBS 10. For example, the template may consist of a set of pre-defined fields or parameters that need to be filled in by the user, such as, but not limited to, input requirements which may define the type and format of the input that the PBS 10 will receive; output requirements which may specify the expected output of the PBS 10 and its format; spatial requirements which may define the spatial requirements of the PBS 10, such as the area of coverage or the position of sensors; temporal requirements which may specify the temporal requirements of the PBS, such as the frequency of updates or the response time; and performance requirements which may define the performance requirements of the PBS, such as the accuracy or the reliability. These predefined fields or parameters in the template can help the user to specify the formal requirements of the PBS 10 in a consistent and structured manner, which can then be used by the system 100 to determine properties of the PBS 10 and further analyse the output of the PBS 10.

By analysing the specification language, the system 100 can identify the necessary properties that need to be satisfied by the PBS 10, which enables it to detect violations and edge cases in output of the PBS 10. In the present system 100, the temporal property analyser 140 determines PBS properties (referred by reference numeral 230) based on an analysis of the received formal requirements 210 of the PBS. Herein, the PBS properties 230 quantifies the formal requirements of the PBS over space and time. The PBS properties 230 refer to the set of formal requirements quantified over space and time. These properties specify how the system 100 should behave and what constraints should be observed for different aspects of the system 100, such as inputs, outputs, and states. The PBS properties 230 help to ensure that behaviour of the system 100 is consistent with the formal requirements, and that the PBS 10 operates as intended.

In an embodiment, the determined PBS properties 230 are in form of Metric First Order Temporal Logic (MFOTL) properties expressed over logical state traces. The system 100 determines the PBS properties 230 by converting the received formal requirements 210 into a form of MFOTL properties, which are expressions that specify the required behaviour of the PBS 10 over space and time. The MFOTL properties are expressed over logical state traces, which represent the evolution of the PBS over time. Herein, each of the logical state traces is a sequence of PBS states at given periodic time-points, and each of the PBS state is expressed as a value for each formal requirements of the PBS at a given time-point. That is, each logical state trace is a sequence of PBS states at given periodic time-points, where each state captures the value for each formal requirement of the PBS at a given time-point. The PBS state captures the values of all the properties that need to be monitored at a given time-point, and the sequence of PBS states forms the logical state trace that represents the evolution of the PBS over time.

Further, as illustrated in FIG 2, for implementation of the system 100, the PBS 10 is provided with a given input (referred by reference numeral 240). In an example, the given input 240 is in the form of a video feed of the PBS 10, which typically consists of a sequence of images captured over time. In such case, an output (referred by reference numeral 242) of the PBS 10 comprises a set of detected objects at each time instance in the video feed of the PBS 10. In particular, the system 100 utilizes the logical trace generator 120 for the said purpose. Specifically, the logical trace generator 120 implements an object tracker (as represented by reference numeral 244), like YOLO, which may use various computer vision techniques, such as object detection or tracking, to identify and track objects in the scene. At each time instance in the video feed, the output 242 of the PBS 10 comprises a set of detected objects, along with their positions, sizes, and other relevant attributes. It may be appreciated that although the object tracker 244 has been shown as part of the logical trace generator 120, it may be implemented in the PBS 10 itself (as described herein) without any limitations.

Further, the logical trace generator 120 implements a system-to-state trace map (as represented by reference numeral 246) which analyses the set of detected objects in the output 242 of the PBS 10 and maps them to a logical representation of the state of the system 100. This involves applying various rules and heuristics that are specific to the domain of the PBS 10, such as rules for determining the identity and motion of objects in the scene. Herein, determined logical state (referred by reference numeral 248) of the PBS 10 at a given time instance represents a high-level abstraction of the state of the system 100, which can be used to reason about the satisfaction of the formal requirements specified in the given input 240. The determined logical state 248 may be represented using a formal language, such as first-order logic or temporal logic, which allows the system 100 to reason about the properties of the PBS 10 over time.

Further, as illustrated in FIG 2, the system 100 determines a temporal robustness value (referred by reference numeral 250) indicative of a degree of closeness between the output 242 of the PBS 10 and a failure of the formal requirements 210 based on the determined PBS properties 230 and the determined logical state 248 of the PBS 10. In particular, the system 100 implements the robustness calculator 130 for the said purpose. Herein, the robustness calculator 130 first uses the determined PBS properties 230, which quantify the formal requirements 210 of the PBS 10 over space and time, and the determined logical state 248 of the PBS 10 at a given time instance to define the satisfaction degree of the PBS 10 with respect to the properties. The robustness calculator 130 then calculates the temporal robustness value 250 by computing the minimum robustness degree over all possible assignments of the formal requirements 210 of the PBS 10 to the detected objects in the output 242 of the PBS 10 at the given time instance. The temporal robustness value 250 quantifies the degree of satisfaction of the PBS 10 with respect to the properties, and it is indicative of how close the output 242 of the PBS 10 is to violating the formal requirements 210 defined therefor.

Herein, a higher temporal robustness value 250 indicates that the PBS output is closer to satisfying the formal requirements, while a lower temporal robustness value 250 indicates that the PBS output is closer to violating the formal requirements. As shown, in an example, the robustness calculator 130 may provide the temporal robustness value 250 in context of "Specification Violation", "Specification Satisfied", or "Edge-Case Detected" (as referred by 'A', 'B' and 'C', respectively, in FIG 2). In the present embodiments, the determined temporal robustness value 250 being zero signifies violation(s) of the PBS, and wherein the determined temporal robustness value 250 between zero and a predetermined threshold signifies edge-case(s) of the PBS. The said predetermined threshold for the temporal robustness value 250 may be defined based on the specific needs and requirements of the system. For example, in safety-critical systems, a lower threshold may be preferred to ensure that any edge-case is detected and flagged for immediate action. However, in less critical systems, a higher threshold may be acceptable, and edge-cases can be dealt with at a later stage. In general, the threshold could be determined through various methods such as trial and error, empirical testing, or based on the specific application domain.

The system 100 further generates a resultant output (as represented by reference numeral 252) indicative of at least one of violation(s) and edge-case(s) of the PBS 10 based on the determined temporal robustness value 250. The resultant output 252 generated by the system 100 can take various forms, depending on the specific implementation and use case. In an embodiment, the given input 240 is in form of a video feed of the PBS 10. In such case, the generated resultant output 252 is in form of a portion of the video feed indicative of the at least one of violation(s) and edge-case(s) of the PBS 10, i.e., the portion of the video feed corresponds to the time instances where a violation or edge-case was detected. For example, if the PBS 10 is monitoring a manufacturing process and a violation is detected where a product is not assembled correctly, the generated resultant output 252 could be a portion of the video feed that corresponds to the time when the error occurred. Similarly, in the case of an edge-case, the generated resultant output 252 could be a portion of the video feed that corresponds to the time instances where the PBS 10 was operating in a critical or unexpected condition, providing insight into potential issues that could be addressed to improve the system's performance.

In general, the resultant output 252 is a feedback mechanism that informs the user or operator of the PBS 10 about the system's performance relative to its formal requirements. For example, the resultant output 252 could be in the form of an alert or notification that is displayed on a user interface, sent as an email or text message, or communicated through an audio or visual signal. The content of the resultant output 252 could include information about the specific formal requirement that has been violated or identified as an edge case, the time and location of the violation or edge case, and the degree of robustness or closeness to the threshold. The resultant output 252 thus enables real-time monitoring and evaluation of performance of the PBS 10, which can help identify and mitigate potential failures or edge-cases before they become critical. The resultant output 252 also provides valuable feedback to the system developers, who can use it to refine and improve the formal requirements and specifications of the PBS 10.

In an embodiment, the system 100 further generates a corrective action for the PBS 10 in response to the at least one of violation(s) and edge-case(s) of the PBS 10 in the generated resultant output 252. That is, the system 100 is designed to not only detect the violations and edge-cases of the PBS 10 based on the generated resultant output 252 but also to provide corrective actions in response to those issues. The corrective action could involve modifying the system parameters or input conditions or issuing alerts to human operators or automated systems. The system 100 may also generate reports or logs of the detected issues and the corresponding corrective actions taken. The goal of providing corrective actions is to ensure that the PBS 10 operates within the formal requirements and performs its intended functions without compromising safety, reliability, and efficiency.

In an embodiment, the system 100 further trains a learning model (not shown), associated with the PBS 10, based on the given input 240 and the generated corrective action for the at least one of violation (s) and edge-case (s) of the PBS 10 corresponding thereto. That is, in addition to generating a corrective action for the PBS 10, the system 100 also utilizes the detected violations and edge-cases to train the learning model associated with the PBS, to improve the performance of the PBS 10 over time by analysing the corrective actions taken for previous violations and edge-cases and adjusting its decision-making process accordingly. The said learning model is trained based on the given input 240, which includes the video feed of the PBS 10, and the generated corrective action for each detected violation and edge-case. By continually improving the PBS 10 through the training of the learning model, the system 100 can enhance the accuracy and reliability of the PBS 10 in detecting and responding to potential failures.

Referring to FIG 3, an overview of approach adopted for the system 100 for online monitoring of the perception-based system 10 is illustrated. As shown, the system 100 receives formal requirements 210 in the form of safety and functional specification, along with the output 242 as result of the input 240 in form of video feed (such as trajectory stream) from the perception-based system/simulator 10. The temporal robustness value 250 in the form of specification satisfaction is transmitted in a user preferred format as the resultant output 252, and further a corresponding feedback 310 (such as, the corrective action as described in the preceding paragraphs) based on the temporal robustness value 250 is communicated back to the PBS 10. The feedback 310 may include information such as the nature of the violation or edge-case and the corresponding corrective action taken by the system 100. By receiving the feedback 310, the PBS 10 can adjust its behaviour to ensure that it meets the formal requirements specified by the user.

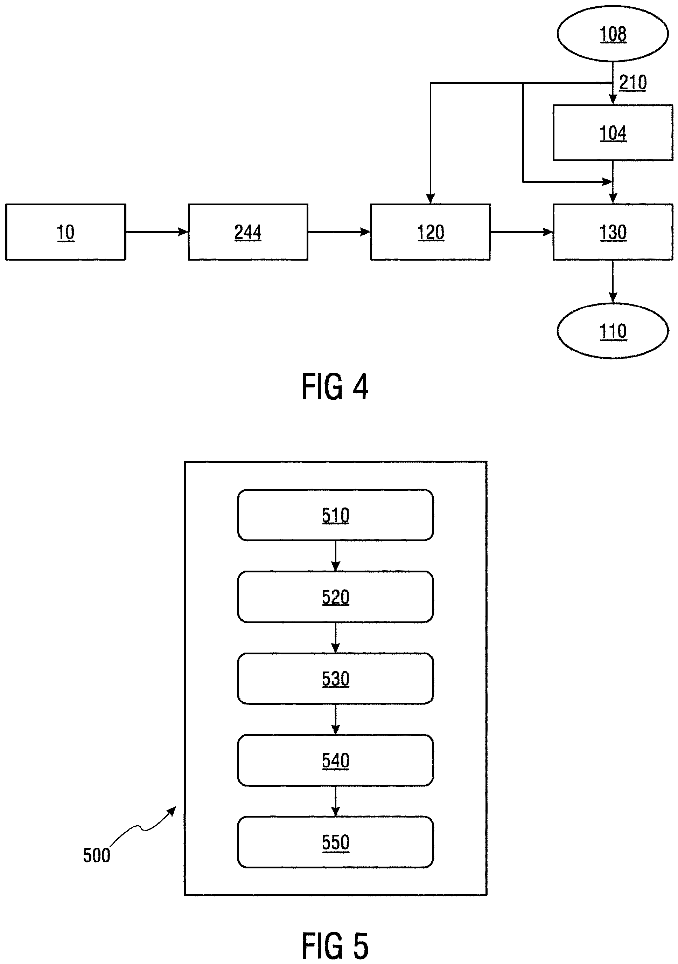

Now, in order to understand the concept of context that maps a variable to an object on a given frame, it is important to first have an understanding of certain notations before describing how the mechanisms of the illustrative embodiments are integrated to perform online monitoring of perception-based systems. It should be appreciated that the method, approach mechanism for performing online monitoring at algorithmic level, as described in FIG 4 and Tables 1 & 2 (below) are only examples and are not intended to state or imply any limitation with regard to mechanisms with which the illustrative embodiments are implemented. Many modifications to the example system may be implemented in various embodiments of the present disclosure without departing from the spirit and scope of the present disclosure.

To begin with, a system trace is defined as a timed state sequences

$$\mathcal{T} = \mathcal{T}_1\mathcal{T}_2\mathcal{T}_3 \dots \mathcal{T}_m = (\tau_1, s_1), (\tau_2, s_2), (\tau_3, s_3), \dots, (\tau_m, s_m),$$

= $(\tau_1, s_1), (\tau_2, s_2), (\tau_3, s_3), \dots, (\tau_m, s_m)$, where for each $k \in \mathbb{N}, \tau_k \geq \mathbb{R}_{\geq 0}$ is a time-stamp and $s_k$ represents the state of the system at the sampling instance k. A uniform sampling rate with sampling period between two instances is assumed to be a constant $\Delta t$. Therefore, the sampling index $i$ directly corresponds to the sampling timestamp $\tau_i$. In one exemplary embodiment, the above notations and the overall approach are based on any of contemporary solutions of online monitoring for temporal robustness algorithm.

For the monitoring of perception-based systems, the output from the object tracker 244 is monitored. Thus, the state at each sampling instance will be a collection of objects $O$, and each object will have associated ID, class, confidence, and bounding box. IDs and objects have a one-to-one relation per sampling instance and can be used interchangeably. A notation $V_O$ is used to represent the set of variables over objects IDs. In one significant embodiment, the present solution uses the concept of *contexts*. A context maps a variable to an object in a given frame.

Next, the formal requirements 210 are stated in Metric Temporal Logic (MTL) with bounded future and un-bounded past $MTL_{pt}^{+\infty}$ that supports bounded and unbounded interval past and bounded interval future operators. Let *AP* be the set of atomic propositions, $V_O$ be the set of all variables ranging over object IDs, *I* be a non-empty interval over $\mathbb{N}$, and $\bar{I}$ be a non-empty interval over $\mathbb{N} \cup \{+\infty\}$. In one example embodiment, the set of valid formulas in $MSTL_{pt}^{+\infty}$, i.e., Metric Spatial Temporal Logic with unbounded past and bounded future operators, are given as follows:

$$\varphi ::= T \mid p \mid \neg\varphi \mid \varphi \wedge \psi \mid \phi \, \mathcal{U}_I \, \psi \mid \phi \, S_{\bar{I}} \, \psi \mid \forall \overline{id}.\varphi \mid \Pi \mid \omega$$

$$\omega ::= ClassEq(id_i, id_j) \mid ProbCmp(id_i, r) \mid ProbScale(id_i, r, id_j) \mid IDEq(id_i, id_j)$$

$$\Pi ::= AreaCmp(id, r) \mid AreaScale(id_i, r, id_j) \mid offsetCmp(\Theta, r)$$
$$\mid OffsetScale(\Theta_i, r, \Theta_j)$$

$$\Theta ::= lat(id, CRT) \mid lon(id, CRT)$$

$$CRT ::= LM \mid RM \mid TM \mid BM \mid CT$$

Here, $p \in AP$ is an atomic proposition, $\overline{id}$ is a vector of object variables, $id_i, id_j \in V_O$, $\omega$ represents the predicates and $\Pi$ represents the spatial operators relevant to perception-based systems. *BBox* gives the bounding box of the object represented by the id. Functions *lat* and *lon* give the latitudinal and longitudinal offsets of the object represented by *id* from the axis specified by CRT.

Herein, the perception-based system 10 emits a stream of states in the form of frames. The object tracker 244 identifies the objects with some probability and determines the bounding-boxes, and assigns IDs to the determined objects. The logical trace generator 120 generates the final trace that contains the values of all object properties (ID, class, probability, Bounding-box) and the values for all other predicates defined by the user based on the formula $\varphi$.

The system uses the formula $\varphi$ to compute the horizon and history at the processor 104 as required by the online algorithm for online monitoring. The logical trace and the values for horizon and history are provided as inputs to the robustness calculator 130 and the result stream is provided as output to the output unit 110. The result stream is a frame-wise result which can be - PASS, FAIL, EDGE-CASE. The result FAIL is a clear violation, and the result EDGE-CASE is a warning that the system is close to violating the specification.

Referring now to Table 1 below, functioning of the robustness calculator 130 is depicted. The primary significance of present disclosure for online monitoring is the presence of contexts. A context is a partial map that maps a variable to an object. Due to the presence of contexts, the size of the robustness table and Pre vector are increased. The width of the robustness table is ((2 x horizon) + history + 1), and the length becomes $\left( |\varphi| \times \prod_{i=1}^{h} P_{r_i}^{n} \right)$ , where $n$ is the number of objects in the current frame, $h$ is the nesting depth of quantifiers, and $r_i$ is the number of bounded variables by quantifier at depth $i$. The robustness table and Pre vector both now have entries for all sub-formulas, under all valid contexts.

$\sigma_i = S_i , ...S_{i+Hrz}$

Compute all the contexts for columns 1-Hst to Hrz and create/update Robustness table $T$ for i

Init/Update **Pre** vector for all Past sub-formulas under all valid contexts

Left-shift all values from AP and predefined predicates under all contexts in $T$

For all Sub-formulas of $\varphi$ under all contexts

If sub-formula $\varphi_k$ with context $\xi_{k,j,c}$ is past operator, then ComputeRobustness($\sigma_i$, $\varphi_k$, j, $\xi_{k,j,c}$), for j from (-Hst + hst($\varphi\_k$)) to Hrz

If sub-formula $\varphi_k$ with context $\xi_{k,j,c}$ is a future operator, then ComputeRobustness($\sigma_i$, $\varphi_k$, j, $\xi_{k,j,c}$), for j from Hrz down to (-Hst + hst($\varphi\_k$))

Return $T_{1,0}$

**Table 1**

Table 2 below illustrates process of computation of robustness, where a positive robustness value means that the trace satisfies the property and a negative robustness means that the specification is not satisfied.

$$\text{Compute Robustness } (\varphi_k, j, \xi_{k,j,c}, \sigma_i)$$

| If $\varphi_k$ is $T\|\neg\varphi\|$ $\psi \wedge \varphi\|\varphi u_i\psi\|\varphi S_I\psi$ | if $\varphi_k$ is $\forall id. (\varphi_m)$ | if $\varphi_k$ is $\omega$ or $\Pi$ |
|---|---|---|
| Compute robustness for context $\xi_{k,j,C}$ and add to T | For all permutations of valid object mapping of id for objects in frame j, with respect to $\xi_{k,j,c}$, $T_{k,j,\xi_{k,j,c}} = T_{k,j,\xi_{k,j,c}} \sqcap T_{m,j,\xi_{m,j,c,c'}}$ | Obtain objects for $id_i$, $id_j$ from context $\xi_{k,j,c}$ and add robustness using distance functions |

**Table 2**

Following from above Table 2, distance function for ω and π are as given below.

$$ClassEq(id_1, id_2) \equiv \begin{cases} +\infty, & if \; Class \; (\xi(id_1)) \; = Class \; (\xi(id_2)) \\ -\infty, & if \; Class \; (\xi(id_1)) \; \neq Class \; (\xi(id_2)) \end{cases}$$

$$IDEq(id_1, id_2) \equiv \begin{cases} +\infty, & if \; ID(\xi(id_1)) \; = ID \; (\xi(id_2)) \\ -\infty, & if \; ID \; (\xi(id_1)) \; \neq ID(\xi(id_2)) \end{cases}$$

$$ProbCmp(id, r) \equiv \begin{cases} dist & if \; dist \; \leq \; 0 \\ -dist & otherwise \end{cases}, where \; dist \; = \; |r - Prob(\xi(id))|$$

$$AreaCmp(id, r) \equiv \begin{cases} dist & if \; dist \; \leq \; 0 \\ -dist & otherwise \end{cases}, where \; dist \; = \; |r - Area(BBox(\xi(id)))|$$

$$OffSetCmp(lat(id, CRT), r) \equiv \begin{cases} dist & if \; dist \; \leq \; 0 \\ -dist & otherwise \end{cases}, where \; dist \; = \; |r - f_{lat}(CRT(\xi(id)))|$$

$$OffSetCmp(lon(id, CRT), r) \equiv \begin{cases} dist & if\ dist\ \leq\ 0 \\ -dist & otherwise \end{cases}, where\ dist\ =\ |r - f_{lon}(CRT(\xi(id)))|$$

$$ProbScale(id_1, r, id_2) \equiv \begin{cases} dist & if\ dist\ \leq\ 0 \\ -dist & otherwise \end{cases}, where\ dist\ =\ \frac{|Prob(\xi(id_1)) - r \times Prob(\xi(id_2))|}{\sqrt{1+r^2}}$$

$$AreaCmp(id_1, r, id_2) \equiv \begin{cases} dist & if\ dist\ \leq\ 0 \\ -dist & otherwise \end{cases}, where\ dist\ =\ \frac{|Area(BBox(\xi(id_1))) - r \times Area(BBox(\xi(id_2)))|}{\sqrt{1+r^2}}$$

$$OffSetCmp(lat(id, CRT), r) \equiv \begin{cases} dist & if\ dist\ \leq\ 0 \\ -dist & otherwise \end{cases}, where\ dist\ =\ \frac{|f_{lat}(CRT(\xi(id_1))) - r \times f_{lat}(CRT(\xi(id_2)))|}{\sqrt{1+r^2}}$$

$$OffSetCmp(lon(id, CRT), r) \equiv \begin{cases} dist & if\ dist\ \leq\ 0 \\ -dist & otherwise \end{cases}, where\ dist\ =\ \frac{|f_{lon}(CRT(\xi(id_1))) - r \times f_{lon}(CRT(\xi(id_2)))|}{\sqrt{1+r^2}}$$

Here, BBox is the top, bottom, left, and right coordinates of the bounding box and area is the rectangular area computed using the length and breadth of bounding box. Similarly, the functions $f_{lat}$ and $f_{lon}$ give the lateral/longitudinal distance of the CRT point of the object from the longitudinal/ lateral axis.

Thus, the system 100 of the present disclosure allows for detection of edge-cases without having to write complicated edge-case scenarios, which is an important requirement for sophisticated systems such as perception-based systems 100. The present system 100 is a clear improvement over general online monitoring system as they detect not only specification violations, but also the edge-cases. Further, the system 100 uses a more expressive logic that is significantly more suitable for perception-based systems, where the actors in the scenario are not predetermined. The domain specific, natural language specifications that are received as an input by the input module eliminates the need of writing custom monitoring code or even model assertions.

In an example implementation, the system 100 may be embodied for use with a robot in a manufacturing facility, where the robot is used for pick-and-place tasks. The robot is required to pick up objects of different shapes and sizes from a conveyor belt and place them in designated containers. The formal requirements of the PBS could include specifications such as the robot should place the objects in the correct containers based on their shapes and sizes; and the robot should operate within a specific time limit. The system 100 would receive these formal requirements expressed in a specification language based on the predefined template. The system 100 would then determine the PBS properties based on an analysis of the received formal requirements. For example, the system could determine that the PBS properties need to ensure that the robot's vision system is accurate and that the robot's gripper is functioning properly.

During operation, the system 100 would analyse the output of the robot, which could be in the form of a video feed, to determine the logical state of the robot at a given time instance. The system 100 may then determine the temporal robustness value indicative of a degree of closeness between the output of the robot and a failure of the formal requirements based on the determined PBS properties and the determined logical state of the robot. If the system 100 detects an edge-case or a violation of the formal requirements, it would generate a resultant output in the form of a portion of the video feed indicating the issue. Based on the resultant output, the system 100 could generate a corrective action for the robot. For example, the system 100 could adjust the robot's vision system or gripper to improve accuracy. The system could also train a learning model associated with the robot based on the generated corrective action to continuously improve the robot's performance over time. The resultant output in the form of specification satisfaction could be transmitted in a user-preferred format, and corresponding feedback based on the resultant output could be communicated back to the robot for further improvements.

Now, referring to FIG 5, illustrated is a flowchart of a method (as represented by reference numeral 500) for managing the perception-based system 10, according to one or more embodiments of the present disclosure. The embodiments herein provide steps illustrated in FIG 5, such as a set of computer-executable instructions and, although a logical order is illustrated in the flow chart, in some cases, the steps illustrated or described may be performed in an order different than here. It may be understood that the various steps of the method 500 as described hereinafter may be executed in the system 100, or specifically in the processor 104 of the system 100, as described above, and thus not repeated herein for brevity of the present disclosure.

At step 510, the method 500 comprises receiving the formal requirements 210 of the PBS 10 expressed in a specification language based on a predefined template. At step 520, the method 500 comprises determining the PBS properties 230 based on an analysis of the received formal requirements 210 of the PBS 10, wherein the PBS properties 230 quantifies the formal requirements 210 of the PBS 10 over space and time. At step 530, the method 500 comprises analysing, for the given input 240, the output 242 of the PBS 10 to determine the logical state 248 thereof at a given time instance. At step 540, the method 500 comprises determining the temporal robustness value 250 indicative of a degree of closeness between the output 242 of the PBS 10 and a failure of the formal requirements 210 based on the determined PBS properties 230 and the determined logical state 248 of the PBS 10. At step 550, the method 500 comprises generating a resultant output 252 indicative of at least one of violation(s) and edge-case(s) of the PBS 10 based on the determined temporal robustness value 250.

In one or more embodiments, the given input 240 is in form of a video feed of the PBS 10. In such case, the generated resultant output 252 is in form of a portion of the video feed indicative of the at least one of violation(s) and edge-case(s) of the PBS 10.

In one or more embodiments, the method 500 further comprises generating a corrective action for the PBS 10 in response to the at least one of violation(s) and edge-case(s) of the PBS 10 in the generated resultant output 252. In some embodiments, the method 500 further comprises training a learning model, associated with the PBS 10, based on the given input 240 and the generated corrective action for the at least one of violation(s) and edge-case(s) of the PBS 10 corresponding thereto.

In one or more embodiments, the predefined template for the specification language is expressive of domain specific safety and functional properties of the PBS 10.

In one or more embodiments, the determined PBS properties 230 are in form of Metric First Order Temporal Logic (MFOTL) properties expressed over logical state traces. Herein, each of the logical state traces is a sequence of PBS 10 states at given periodic time-points. Further, herein each of the PBS state is expressed as a value for each formal requirements 210 of the PBS 10 at a given time-point.

In one or more embodiments, the given input 240 is in the form of a video feed of the PBS 10. Herein, the output 242 of the PBS 10 comprises a set of detected objects at each time instance in the video feed of the PBS 10.

In one or more embodiments, the determined temporal robustness value 250 being zero signifies violation (s) of the PBS 10. Herein, the determined temporal robustness value 250 between zero and a predetermined threshold signifies edge-case(s) of the PBS 10.

The present disclosure may take a form of a computer program product comprising program modules accessible from computer-usable or computer-readable medium storing program code for use by or in connection with one or more computers, processors, or instruction execution system. For the purpose of this description, a computer-usable or computer-readable medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processors and program code for implementing each aspect of the technology can be centralized or distributed (or a combination thereof) as known to those skilled in the art.

Advantageously, using the system 100 and the method 500 of the present disclosure, online monitoring of perception-based systems (PBS) for detection of edge-cases is realized. Precisely, the system 100 and the method 500 offers the benefit of detecting the safety and correctness of PBS in real-time, in a fine-grained and precise manner. This safety detection is enhanced by gaining an understanding well in advance of possibility of failure in future, based on current state of system. These scenarios referred to as edge-cases are beneficial in enabling the transfer of control back to safe modules/human operators when the system is about to crash or shows a deviation from standard protocol. The present system 100 and the method 500 solution achieves the above hypothesis by expressing rich functional and safety properties of PBS, followed by real time monitoring and detection of violations of specifications in a manner most convenient for the user.

The foregoing examples have been provided merely for the purpose of explanation and are in no way to be construed as limiting of the present disclosure disclosed herein. While the invention has been described with reference to various embodiments, it is understood that the words, which have been used herein, are words of description and illustration, rather than words of limitation. Further, although the invention has been described herein with reference to particular means, materials, and embodiments, the invention is not intended to be limited to the particulars disclosed herein; rather, the invention extends to all functionally equivalent structures, methods and uses, such as are within the scope of the appended claims.

REFERENCE NUMERALS

| | |
|---|---|
| perception-based system | 10 |
| system | 100 |
| computer network | 102 |
| processor | 104 |
| memory | 106 |
| input device | 108 |
| output device | 110 |
| logical trace generator | 120 |
| robustness calculator | 130 |
| temporal property analyser | 140 |
| formal requirements | 210 |
| interface | 220 |
| PBS properties | 230 |
| input | 240 |
| output | 242 |
| object tracker | 244 |
| system-to-state trace map | 246 |
| logical state | 248 |
| temporal robustness value | 250 |
| resultant output | 252 |
| feedback | 310 |
| method | 500 |
| step | 510 |
| step | 520 |
| step | 530 |
| step | 540 |
| step | 550 |

**Claims**

1. A method (500) for managing a perception-based system (PBS) (10), the method (500) comprising:

   receiving formal requirements (210) of the PBS (10) expressed in a specification language based on a predefined template;
   determining PBS properties (230) based on an analysis of the received formal requirements (210) of the PBS (10), wherein the PBS properties (230) quantifies the formal requirements (210) of the PBS (10) over space and time;
   analysing, for a given input (240), an output of the PBS (10) to determine a logical state (248) thereof at a given time instance;
   determining a temporal robustness value (250) indicative of a degree of closeness between the output (242) of the PBS (10) and a failure of the formal requirements (210) based on the determined PBS properties (230) and the determined logical state (248) of the PBS (10); and
   generating a resultant output (252) indicative of at least one of violation(s) and edge-case(s) of the PBS (10) based on the determined temporal robustness value (250).

2. The method (500) according to claim 1, wherein the given input (240) is in form of a video feed of the PBS (10), and wherein the generated resultant output (252) is in form of a portion of the video feed indicative of the at least one of violation(s) and edge-case(s) of the PBS (10).

3. The method (500) according to claim 1 further comprising generating a corrective action for the PBS (10) in response to the at least one of violation(s) and edge-case(s) of the PBS (10) in the generated resultant output (252).

4. The method (500) according to claim 4 further comprising training a learning model, associated with the PBS (10), based on the given input (240) and the generated corrective action for the at least one of violation(s) and edge-case(s) of the PBS (10) corresponding thereto.

5. The method (500) according to claim 1, wherein the predefined template for the specification language is expressive of domain specific safety and functional properties of the PBS (10).

6. The method (500) according to claim 1, wherein the determined PBS properties (230) are in form of Metric First Order Temporal Logic (MFOTL) properties expressed over logical state traces, and wherein each of the logical state traces is a sequence of PBS states at given periodic time-points, and wherein each of the PBS state is expressed as a value for each formal requirements (210) of the PBS (10) at a given time-point.

7. The method (500) according to claim 1, wherein the given input (240) is in the form of a video feed of the PBS (10), and wherein the output (242) of the PBS (10) comprises a set of detected objects at each time instance in the video feed of the PBS (10).

8. The method (500) according to claim 1, wherein the determined temporal robustness value (250) being zero signifies violation(s) of the PBS (10), and wherein the determined temporal robustness value (250) between zero and a predetermined threshold signifies edge-case(s) of the PBS (10) .

9. A system (100) for managing a perception-based system (PBS) (10), the system (100) comprising:

   an interface providing a predefined template, wherein the interface is configured to receive formal requirements (210) of the PBS (10) expressed in a specification language based on the predefined template;
   a processor; and
   a memory coupled to the processor, wherein the memory comprises instructions which, when executed by the processor, configures the processor to:

   determine PBS properties (230) based on an analysis of the received formal requirements (210) of the PBS (10), wherein the PBS properties (230) quantifies the formal requirements (210) of the PBS (10) over space and time;
   analyse, for a given input (240), an output of the PBS (10) to determine a logical state (248) thereof at a given time instance;
   determine a temporal robustness value (250) indicative of a degree of closeness between the output (242) of the PBS (10) and a failure of the formal requirements (210) based on the determined PBS properties (230) and the determined logical state (248) of the PBS (10); and
   generate a resultant output (252) indicative of at least one of violation (s) and edge-case (s) of the PBS (10) based on the determined temporal robustness value (250) .

10. A computer-program product, having machine-readable instructions stored therein, that when executed by a processor, cause the processor to perform method (500) steps according to any of the claims 1-8.

FIG 1

FIG 2

FIG 3

108

210

104

10 → 244 → 120 → 130

110

# FIG 4

500

510

520

530

540

550

# FIG 5

# EUROPEAN SEARCH REPORT

| | Application Number |
|---|---|
| | EP 23 16 5627 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CUMHUR ERKAN TUNCALI ET AL: "Requirements-driven Test Generation for Autonomous Vehicles with Machine Learning Components", ARXIV.ORG, CORNELL UNIVERSITY LIBRARY, 201 OLIN LIBRARY CORNELL UNIVERSITY ITHACA, NY 14853, [Online] 3 August 2019 (2019-08-03), XP081455266, [retrieved on 2023-09-15] | 1-10 | INV. G06F11/36 B60W50/00 G06F30/20 |
| Y | * abstract; figures 1-15 * * page 3, column 1, paragraph III. Preliminaries – page 14, column 1, paragraph VII. Conclusions * * the whole document * ----- | 1-10 | |
| X | ROOP PARTHA ET AL: "Encoding and monitoring responsibility sensitive safety rules for automated vehicles in signal temporal logic", PROCEEDINGS OF THE 17TH ACM-IEEE INTERNATIONAL CONFERENCE ON FORMAL METHODS AND MODELS FOR SYSTEM DESIGN, [Online] 9 October 2019 (2019-10-09), pages 1-11, XP055955880, New York, NY, USA DOI: 10.1145/3359986.3361203 ISBN: 978-1-4503-6997-8 Retrieved from the Internet: URL:https://dl.acm.org/doi/pdf/10.1145/3359986.3361203> [retrieved on 2023-09-15] * the whole document * ----- | 1-10 | |
| | | | TECHNICAL FIELDS SEARCHED (IPC) |
| | | | G06F B60W |
| Y | CN 114 936 134 A (UNIV NANJING AERONAUTICS & AUSTRONAUTICS) 23 August 2022 (2022-08-23) * the whole document * ----- | 1-10 | |

-/--

The present search report has been drawn up for all claims

| Place of search | Date of completion of the search | Examiner |
|---|---|---|
| Munich | 18 September 2023 | Bozas, Ioannis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/379893 A1 (ARECHIGA GONZALEZ NIKOS [US] ET AL) 3 December 2020 (2020-12-03) * abstract; figures 1-7 * * paragraph [0002] – paragraph [0064] * * the whole document * ----- | 1-10 | |

TECHNICAL FIELDS
SEARCHED      (IPC)

The present search report has been drawn up for all claims

| Place of search | Date of completion of the search | Examiner |
|---|---|---|
| Munich | 18 September 2023 | Bozas, Ioannis |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 23 16 5627

This annex lists the patent family members relating to the patent documents cited in the above-mentioned European search report.
The members are as contained in the European Patent Office EDP file on
The European Patent Office is in no way liable for these particulars which are merely given for the purpose of information.

18-09-2023

| Patent document cited in search report | | Publication date | Patent family member(s) | Publication date |
|---|---|---|---|---|
| CN 114936134 | A | 23-08-2022 | NONE | |
| US 2020379893 | A1 | 03-12-2020 | NONE | |

For more details about this annex : see Official Journal of the European Patent Office, No. 12/82

EPO FORM P0459